# EUROPEAN PATENT SPECIFICATION

(11) **EP 0 343 568 B1**
(45) Date of publication and mention of the grant of the patent: **05.05.1993**
(21) Application number: 89109185.2
(22) Date of filing: 22.05.1989
(51) Int. Cl.: C01G 29/00, C04B 35/00, H01L 39/24

(54) **Process for preparing compound metal oxide**
Verfahren zur Herstellung einer Metalloxid-Verbindung
Procédé de préparation d'un composé d'oxyde métallique

(30) Priority: 23.05.1988 JP 123972/88; 13.06.1988 JP 143595/88
(43) Date of publication of application: 29.11.1989
(73) Proprietor: MITSUBISHI MATERIALS CORPORATION, Chiyoda-ku Tokyo (JP)
(72) Inventor: Sakai, Kazuhiro, Saitama-ken (JP)
(74) Representative: Strehl Schübel-Hopf Groening & Partner

(56) References cited:
- EP-A- 0 301 591
- DE-A- 2 548 387
- CHEMISTRY LETTERS, 1988, pages 1515-1516, The Chemical Society of Japan; H. YAMANE et al.: "Preparation of Bi-Sr-Ca-Cu-O films by chemical vapor deposition with metal chelate and alkoxide"

## Description

### Field of the Invention

This invention relates to a process for preparing compound metal oxides.

More particularly, this invention relates to a process for preparing compound metal oxides of specific compositions, which are useful as superconductors, oxygen sensors, catalysts, etc. Compound metal oxides of bismuth (Bi), strontium (Sr), calcium (Ca) and copper (Cu) of specific compositions are known as superconductive substances which turn superconductive at no lower than 77K and have been attracting the attention of scientists. This invention relates to a process for preparing Bi-Sr-Ca-Cu compound oxides.

This invention also relates to a process for preparation of a process for preparing thin film of Bi-Sr-Ca-Cu compound oxides.

### Background of the Invention

Typical processes known today for preparation of compound metal oxides are:
(1) a process comprising physically pulverizing and mixing oxide, carbonate or oxalate of the respective metals, firing the mixture and pulverizing the fired mixture;
(2) a process comprising preparing a homogeneous aqueous solution of a water-soluble salt such as nitrate, hydrochloride, etc. of the respective metals, adding hydroxide ions, carbonate ions, oxalate ions or the like to the solution to form insoluble coprecipitate of hydroxides, carbonates, oxalates or the like of the metals, collecting the precipitate and firing it; etc.

Rather recently there has been developed
(3) a process comprising preparing a homogeneous organic solution of the component metals by dissolving alkoxides or β-diketo complex or β-diketoester complex of the metals in an organic solvent, hydrolyzing the metal compounds, collecting the formed precipitate and firing the collected precipitate.

In the process (1), mixed powder is fired. Therefore, the reaction proceeds from the boundary of the particles and is liable to leave unreacted cores. This means that the products are not homogeneous and the composition thereof deviates from the intended composition.

In the process (2), conditions for precipitation differ from element to element in a solution. Therefore, from a solution containing a plurality of metals in a specific content ratio, it is difficult to obtain a compound metal oxide in which the metals are contained in the same content ratio as in the solution. Further, inorganic anions (NO₃⁻, Cℓ⁻, SO₄²⁻, etc.) remain as impurities ever if the products are fired, which degrade the properties of the products.

In the process (3), although precipitates of the intended composition are obtainable, organic substances remain as carbon even if the precipitate is fired, which degrades the properties of the products.

When thin film of compound metal oxides is formed, sputtering or similar methods must be resorted to, and expensive apparatuses such as sputtering apparatus, hot press, etc. are required.

Rather recently, there has been proposed a process for preparing thin film of compound metal oxides comprising dissolving alkoxides, β-diketo complex, β-ketoester complex or organic acid salts of the component metals in an organic solvent to form a homogeneous solution, applying the solution on the surface of a substrate to form a coating of the mixed solutes, hydrolyzing the mixed solutes with moisture in the atmosphere and firing the hydrolyzation product. In this process, firing is required in order to remove remaining organic substances and hydroxyl radicals and often carbon remains, which degrades the quality of the product.

We have found that a compound metal oxide of bismuth, strontium, calcium and copper can be prepared by refluxing an organic solution containing alkoxides, of bismuth, strontium and calcium and organic acid salts or β-diketo complex or β-ketoester complex of copper, and irradiating the resulting product simultaneously with UV rays and IR rays after removing the solvent.

Also we have found that thin film of a compound metal oxide of bismuth, strontium, calcium and copper can be prepared by applying the above-described refluxed reaction mixture on a substrate, and simultaneously irradiating it with UV rays and IR rays after the solvent is removed by evaporation.

Further we have found that when the above organic solution is refluxed, if water or an aqueous solution of a base is added, a compound metal hydroxide is formed and it is converted to oxide by irradiation with UV rays or IR rays.

### Disclosure of the Invention

This invention provides a process for preparing a compound metal oxide comprising dissolving a C₁-C₆ alkoxide of bismuth, a C₁-C₆ alkoxide of strontium, a C₁-C₆ alkoxide of calcium and a formate, propionate, acetate, citrate, gluconate, tartrate, oxalate, naphthenate, 2-ethylhexanoate or a β-diketo complex or β-ketoester complex of copper in an organic solvent in the same content ratio with respect to metals as that in the object compound, refluxing the solution, and irradiating the reaction product with UV rays and IR rays after removing the solvent.

This invention also provides a process for preparing thin film of a Bi-Sr-Ca-Cu compound metal oxide comprising applying the above-described reaction mixture after refluxing on a substrate and irradiating it with UV rays and IR rays simultaneously.

Further, this invention provides a process for preparing a Bi-Sr-Ca-Cu compound metal complex comprising refluxing the above described solution to which water or an aqueous solution of a base has been added and irradiating the refluxed reaction mixture after the solvent is removed.

Still further, this invention provides a process for preparing thin film of a Bi-Sr-Ca-Sr-Cu compound metal complex comprising applying the suspension of the reaction product mixture of the above refluxing in the presence of water or a base on a substrate, removing the solvent and irradiating the residual film with UV and IR rays.

In the process of the present invention, bismuth alkoxide is a compound represented by the formula Bi(OR¹)(OR²)(OR³) wherein R¹, R² and R³ are the same or different C₁-C₆ alkyl.

In the present invention, strontium alkoxide and calcium alkoxide are compounds represented by the formula A(OR¹)(OR²) wherein A is Sr or Ca and R¹ and R² are the same or different C₁-C₆ alkyl. C₁-C₄ alkoxides are preferred.

In the present invention, acetate, naphthenate and 2-ethylhexanoate of copper are preferred as organic acid salts of copper.

β-Diketo complex and β-ketoester complex of copper are represented by the formula Cu(OR)ℓ(X)ₘ, wherein R is C₁-C₆ alkyl; ℓ is 0 or 1, m is 1 or 2 and ℓ + m = 2; and X is a group represented by the formula 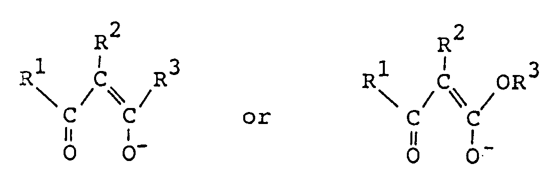
wherein R¹ and R³ are C₁-C₆ alkyl and R² is hydrogen or C₁-C₆ alkyl.

In the process of the present invention, almost all organic solvents can be used insofar as they dissolve the above alkoxides and copper complexes and are inert to these substances. Specific examples are esters such as ethyl acetate, ethyl propionate, etc.; alcohols such as methyl alcohol, ethyl alcohol, n- and iso-propyl alcohol, n-, iso-, sec- and tert- butyl alcohol, n-pentyl alcohol, iso-amyl alcohol, hexyl alcohol, octyl alcohol, etc.; aliphatic saturated hydrocarbons such as pentane, hexane, cyclohexane, methylcyclohexane, etc.; aromatic hydrocarbons such as benzene, toluene, xylene, etc.; cyclic ethers such as tetrahydrofuran, dioxane, etc.; cellosolves such as methyl cellosolve, ethyl cellosolve, butyl cellosolve, etc.; formamides such as dimethylformamide, diethyformamide, etc.; and sulfoxides such as dimethysulfoxide, diethylsulfoxide, etc. These solvents can be used singly or in combination. Alcohols and hydrocarbons are preferred.

The solvents should preferably be throughly dried and free from carbon dioxide. The amount of the solvent used is not specifically limited. It is used in an amount that enables the four components to react most suitably.

When water is used to hydrolyze the alkoxides and keto complexes, there is no specific limitation on the amount of water to be used. The base is simply a catalyst. The preferred base is ammonia.

When the alkoxides and keto complexes are hydrolyzed in the presence of water or water and base, there is no specific limitation on the pH of the solution.

The amount of water and the pH will be determined so that the four components are completely precipitated.

In the process of the present invention, dissolution of the starting materials is accelerated by warming. However, the temperature should preferably be not higher than 100°C so that the starting materials do not decompose.

The solution is kept at the boiling temperature of the solvent used. It is believed that a compound alkoxide of the four metals is formed. The refluxing should preferably be conducted sufficiently. By this operation, polymerization of the compound alkoxide proceeds, which enables formation of good compound metal oxide at a relatively low temperature in the thermal decomposition that follows.

When the reluxing is conducted in the presence of water or water and a base, it is believed that a compound metal hydroxide is formed and polymerized to some extent.

In the process of the present invention, irradiation with UV rays and IR rays is conducted in vacuum, on an atmosphere of an inert gas, oxygen, air or nitrous oxide, after the solvent is removed.

When thin film is formed, it is convenient to apply the resultant refluxing reaction mixture to the substrate as a solution or a suspension.

In the processes of the present invention, C₁-C₆ alkoxides of bismuth, strontium and calcium and the above mentioned organic acid salts, β-diketo complex and β-keto complex of copper are easily purified to a high degree by distilation and recrystallization. Therefore, highly pure compound metal oxides can be obtained. According to the present invention, no thermal energy for firing as is required in the known processes is needed. Thin film of compound metal oxide having specific characteristics can be easily prepared.

### Specific Description of the Invention

The invention will now be illustrated by way of working examples.

### Example 1

Bismuth triisopropoxide Bi[OCH(CH₃)₂]₃ (19.3 g), strontium diisopropoxide Sr[OCH(CH₃)₂]₂ (10.28 g), calcium diisopropoxide Ca[OCH(CH₃)₂]₂ (75 g) and copper acetyl acetonate Cu(CH₃COCHCOCH₃)₂ (26.15 g) were dissolved in 1000 mℓ of isopropanol, and the solution was refluxed at the boiling point of isopropanol for 3 hours. The isopropanol was distilled off and a solid product (powder) was obtained. The product was uniformly spread in a Petri dish having a diameter of 10 cm and the dish was placed in a quartz chamber 10 cm in depth and 20 cm x 20 cm in horizontal cross section. The chamber had a gas inlet and a gas outlet. The product was irradiated with UV rays from a low pressure mercury lamp and IR rays from an IR lamp simultaneously for 1 hour. The temperature of the irradiated powder was measured and found to be about 700°C. The resultant product was analyzed by the X-ray diffraction method. The data corresponded to that of the compound reported as BiSrCaCu₂O_{5.5}. The powder was compacted under a pressure of 1.5 t/cm², and the superconductivity critial temperature Tc was measured and found to be 78K.

### Example 2

Bismuth triisopropoxide Bi[OCH(CH₃)₂]₃, strontium diisopropoxide Sr[OCH(CH₃)₂]₂ and calcium diisopropoxide Ca[OCH(CH₃)₂]₂ were dissolved in isopropanol and copper acetylacetonate Cu(CH₃COCHCOCH₃)₂ in benzene so that the metal concentration was 0.035 mol/ℓ respectively. Each 200 mℓ, 200 mℓ, 100 mℓ, and 200 mℓ of the solutions were taken, mixed and thoroughly stirred. The mixture was refluxed for 4 hours. Thereafter, the solvent was distilled off and put in a Petri dish and irradiated in the same manner for 20 hours. The temperature of the irradiated powder rose to 820°C.

The powder was analyzed by the X-ray diffraction method and the data corresponded to that of a compound reported as Bi₂Sr₂CaCu₂O₈. The powder was compacted under a pressure of 1.5 t/cm² and the superconductivity critical temperature Tc was measure and found to be 83K.

### Example 3

Bismuth triisopropoxide Bi[OCH(CH₃)₂]₃ (19.3 g), strontium diisopropoxide Sr[OCH(CH₃)₂]₂ (10.28 g), calcium diisopropoxide Ca[OCH(CH₃)₂]₂ (7.9 g) and copper acetylacetonate Cu(CH₃COCHCOCH₃)₂ (20.15g) were dissolved in 1000 mℓ of isopropanol, and the solution was refluxed at the boiling point of isopropanol for 2 hours. Then 30 mℓ of ammonical water having a pH of 11 was added to the reaction mixture and refluxing was further continued for 3 hours. Precipitate was formed. The precipitate was collected and spread in a Petri dish having a diameter of 10 cm, and the dish was placed in a quartz chamber provided with a gas inlet and a gas outlet. UV rays from a low pressure mercury lamp and IR rays from an IR lamp were directed onto the precipitate from the upper side simultaneously for 1 hour. The resulting powder was spread uniformly in a Petri dish, the dish was placed in a quartz chamber 10 cm in depth and 20 cm x 20 cm in, horizontal cross section, and the powder was irradiated by UV rays from a low pressure mercury lamp and IR rays from an IR lamp simultaneously from above for 1 hour as oxygen was circulated through the chamber. The temperature of the irradiated powder rose to about 800°C. The resultant powder was analyzed by X-ray diffraction method. The data corresponded to that of a compound reported as BiSrCaCu₂O_{5.5}. The powder was compacted under a pressure of 1.5 t/cm², and its superconductivity critical temperature (Tc) was measured and found to be 76K.

### Example 4

Bismuth triisopropoxide Bi[OCH(CH₃)₂]₃ (19.3 g), strontium diisopropoxide Sr[OCH(CH₃)₂]₂ (10.28 g) calcium diisopropoxide Ca[OCH(CH₃)₂]₂ (7.9 g) and copper acetylacetate Cu(CH₃COCHCOCH₃)₂ (26.15 g) were dissolved in 1000 mℓ of isopropanol. The solution was refluxed at the boiling point of isopropanol for 3 hours. The resultant solution was applied to the surface of a 3 cm x 3 cm x 1 mm magnesium oxide plate. After drying, the plate was placed in a quartz chamber 5 cm in depth and 20 cm x 20 cm in horizontal cross section with the coated side upward, and UV rays from a low pressure mercury lamp and IR rays from an IR lamp were directed onto the plate simultaneously from above for 30 minutes. The temperature of the substrate was raised to about 780°C. The above-described procedures of coating and irradiation were repeated 10 times. The resultant surface of this plate was quantitatively analyzed with an X-ray microanalyzer. The results revealed that Bi:Sr:Ca:Cu:O=1:1:1:2:5.5. The superconductivity critical temperature (Tc) of this thin film was 75K.

### Example 5

Bismuth triethoxide Bi(OC₂H₅)₃ (17.2 g), strontium diethoxide Sr(OC₂H₅)₂ (8.88 g), calcium diethoxide Ca(OC₂H₅)₂ (6.5 g) and copper 2-ethylhexanoate Cu[C₄H₃CH(C₂H₅)COO]₂ (34.99 g) were dissolved in 1000 mℓ of ethanol. The solution was refluxed at the boiling point of ethanol for 3 hours. The resultant solution was applied to the surface of a 1 mm x 3 cm x 3 cm zirconium oxide plate. After drying, the plate was placed in a quartz chamber 5 cm in depth and 20 cm x 20 cm in horizontal cross section provided with a gas inlet and a gas outlet. UV rays from a low pressure mercury lamp and IR rays from an IR lamp were directed to the plate simultaneously from the above for 1 hour. The temperature of the substrate rose to about 800°C. The above-described procedures of coating and irradiation were repeated 5 times. The resultant surface of this plate was analyzed with an X-ray microanalyzer. The results showed that Bi:Sr:Ca:Cu:O = 1:1:1:2:5.5. The superconductivity critical temperature (Tc) of this thin film was 78K.

### Example 6

Bismuth triisopropoxide Bi[ OCH(CH₃)₂]₃ (19.3 g), strontium diethoxide Sr(OC₂H₅)₂ (8.88 g), calcium dimethoxide Ca(OCH₃)₂ (5.1 g) and copper acetylacetonate Cu(CH₃COCHCOCH₃)₂ (26.15 g) were dissolved in 1000 mℓ of benzene. The solution was refluxed for 2 hours at the boiling point of benzene. The resultant solution was applied to the surface of a 0.5 mm x 3 cm x 3 cm silicon wafer. After drying in the air, the wafer was placed with the coated side upward in a quartz chamber 5 cm in depth and 20 cm x 20 cm in horizontal cross section provided with a gas inlet and a gas outlet. UV rays from a low pressure mercury lamp and IR rays from an IR lamp were directed simultaneously from the above for 2 hours as oxygen was circulated. The temperature of the substrate was raised to about 750°C. The surface was analyzed with an X-ray microanalyzer and the results revealed that Bi:Sr:Ca:Cu:O=1:1:1:2:5.5. The superconductivity critical temperature (Tc) of this thin film was 76K.

## Claims

1. A process for preparing a compound metal oxide of bismuth, strontium, calcium and copper comprising:
dissolving
(1) a C₁-C₆-alkoxide of bismuth,
(2) a C₁-C₆-alkoxide of strontium,
(3) a C₁-C₆-alkoxide of calcium, and
(4) a formate, propionate, acetate, citrate, gluconate, tartrate, oxalate, naphthenate, 2-ethylhexanoate, β-diketo complex or β-ketoester complex of copper represented by the formula
Cu(OR)ₗ(X)ₘ,
wherein R is C₁-C₆-alkyl, l is 0 or 1, m is 1 or 2 and l+m=2 and X is represented by the formula 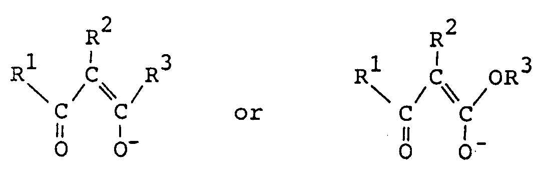 wherein R¹ and R³ are C₁-C₆-alkyl and R² is hydrogen or C₁-C₆-alkyl,
in an organic solvent in the same content ratio of the metals as that in the object compound metal oxide;
allowing the mixture to react at the refluxing temperature;
removing the solvent; and
irradiating the residue with UV rays and IR rays simultaneously.

2. The process according to claim 1, wherein C₁-C₄-alkoxides of bismuth, strontium and calcium are used.

3. The process according to claim 1 or 2, wherein a solvent selected from alcohols and aliphatic and aromatic hydrocarbons is used.

4. The process according to any one of claims 1 to 3, wherein acetate, naphthenate, 2-ethylhexanoate or acetylacetonate of copper is used as copper source.

5. The process according to any one of claims 1 to 4, wherein UV rays from a low pressure mercury lamp are employed.

6. The process according to any one of claims 1 to 5, wherein refluxing is conducted in the presence of water.

7. The process according to claim 6, wherein refluxing is conducted in the presence of water and a base catalyst.

8. The process according to any one of the preceding claims, wherein the refluxing reaction product is applied on the surface of a substrate and irradiated after evaporation of the solvent, whereby a thin film of said compound metal oxide is formed.

9. A process for forming a thin film of a compound metal oxide on a substrate comprising:
applying to the surface of the substrate the refluxed reaction product of an organic solvent solution containing
(1) a C₁-C₆-alkoxide of bismuth,
(2) a C₁-C₆-alkoxide of strontium,
(3) a C₁-C₆-alkoxide of calcium, and
(4) a formate, propionate, acetate, citrate, gluconate, tartrate, oxalate, naphthenate, 2-ethylhexanoate, β-diketo complex or β-ketoester complex of copper represented by the formula
Cu(OR)ₗ(X)ₘ,
wherein R is C₁-C₆-alkyl, l is 0 or 1, m is 1 or 2 and l+m=2 and X is represented by the formula 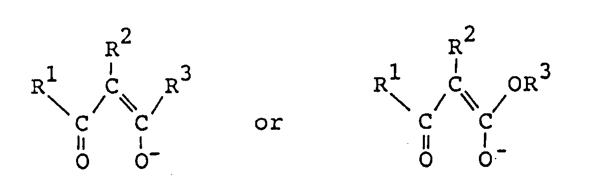 wherein R¹ and R³ are C₁-C₆-alkyl and R² is hydrogen or C₁-C₆-alkyl,
in the same content ratio of the metals as that in the object compound metal oxide;
removing the solvent; and
irradiating the residue with UV rays and IR rays simultaneously.

## Patentansprüche

1. Verfahren zur Herstellung eines Verbund-Metalloxids von Bismut, Strontium, Calcium und Kupfer umfassend:
das Lösen
(1) eines C₁₋₆-Alkoxids von Bismut,
(2) eines C₁₋₆-Alkoxids von Strontium,
(3) eines C₁₋₆-Alkoxids von Calcium und
(4) eines Formiats, Propionats, Acetats, Citrats, Gluconats, Tartrats, Oxalats, Naphthenats, 2-Ethylhexanoats, β-Diketo-Komplexes oder β-Ketoester-Komplexes von Kupfer, dargestellt durch die Formel
Cu(OR)ₗ(X)ₘ,
in der R C₁₋₆-Alkyl ist, l 0 oder 1 ist, m 1 oder 2 ist und l+m=2 und X durch die Formel dargestellt ist 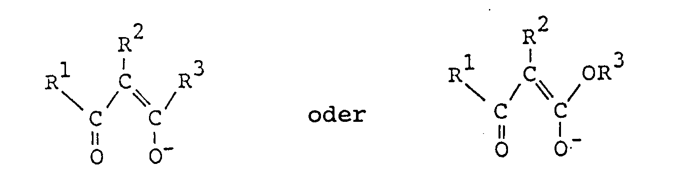 in der R¹ und R³ C₁₋₆-Alkyl sind und R² Wasserstoff oder C₁₋₆-Alkyl ist,
in einem organischen Lösungsmittel in dem gleichen Mengenverhältnis der Metalle wie das in dem gewünschten Verbund-Metalloxid;
das Reagierenlassen des Gemisches bei der Rückflußtemperatur;
das Entfernen des Lösungsmittels; und
das gleichzeitige Bestrahlen des Rückstands mit UV-Strahlen und IR-Strahlen.

2. Verfahren nach Anspruch 1, bei dem C₁₋₄-Alkoxide von Bismut, Strontium und Calcium verwendet werden.

3. Verfahren nach Anspruch 1 oder 2, bei dem ein Lösungsmittel, ausgewählt unter Alkoholen und aliphatischen und aromatischen Kohlenwasserstoffen, verwendet wird.

4. Verfahren nach einem der Ansprüche 1 bis 3, bei dem das Acetat, Naphthenat, 2-Ethylhexanoat oder Acetylacetonat von Kupfer als Kupferquelle verwendet wird.

5. Verfahren nach einem der Ansprüche 1 bis 4, bei dem UV-Strahlen aus einer Niederdruck-Quecksilberlampe verwendet werden.

6. Verfahren nach einem der Ansprüche 1 bis 5, bei dem das Sieden unter Rückfluß in Gegenwart von Wasser durchgeführt wird.

7. Verfahren nach Anspruch 6, bei dem das Sieden unter Rückfluß in Gegenwart von Wasser und eines basischen Katalysators durchgeführt wird.

8. Verfahren nach einem der vorstehenden Ansprüche, bei dem das Reaktionsprodukt des Siedens unter Rückfluß auf die Oberfläche eines Substrats aufgebracht und nach dem Entfernen des Lösungsmittels bestrahlt wird, wodurch ein dünner Film des genannten Verbund-Metalloxids gebildet wird.

9. Verfahren zur Herstellung eines dünnen Films eines Verbund-Metalloxids auf einem Substrat umfassend:
das Aufbringen auf die Oberfläche eines Substrats des unter Rückfluß erhitzten Reaktionsprodukts einer organischen Lösungsmittel-Lösung enthaltend
(1) eines C₁₋₆-Alkoxids von Bismut,
(2) eines C₁₋₆-Alkoxids von Strontium,
(3) eines C₁₋₆-Alkoxids von Calcium und
(4) eines Formiats, Propionats, Acetats, Citrats, Gluconats, Tartrats, Oxalats, Naphthenats, 2-Ethylhexanoats, β-Diketo-Komplexes oder β-Ketoester-Komplexes von Kupfer, dargestellt durch die Formel
Cu(OR)ₗ(X)ₘ,
in der R C₁₋₆-Alkyl ist, l 0 oder 1 ist, m 1 oder 2 ist und l+m=2 und X durch die Formel dargestellt ist 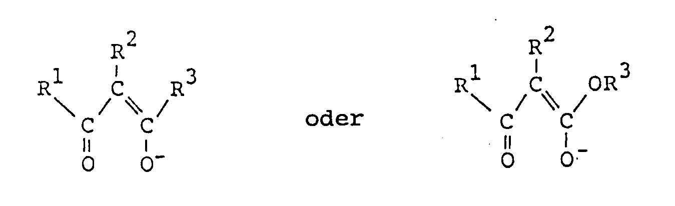 in der R¹ und R³ C₁₋₆-Alkyl sind und R² Wasserstoff oder C₁₋₆-Alkyl ist,
in dem gleichen Mengenverhältnis der Metalle wie dem in dem gewünschten verbund-Metalloxid;
das Entfernen des Lösungsmittels; und
das gleichzeitige Bestrahlen des Rückstands mit UV-Strahlen und IR-Strahlen.

## Revendications

1. Un procédé pour préparer un composé d'oxydes métalliques de bismuth, de strontium, de calcium et de cuivre, qui consiste à :
dissoudre
(1) un alcoolate en C₁-C₆ de bismuth,
(2) un alcoolate en C₁-C₆ de stontium,
(3) un alcoolate en C₁-C₆ de calcium et
(4) un formiate, propionate, acétate, citrate, gluconate, tartrate, oxalate, naphténate, 2-éthylhexanoate, complexe β-dicéto ou complexe β-cétoester de cuivre représentés par la formule
Cu(OR)ₗ(X)ₘ
dans laquelle R est un alkyle en C₁-C₆, l est 0 ou 1, m est 1 ou 2 et l + m = 2, et X est représenté par la formule 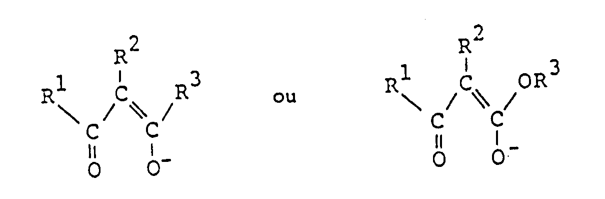 où R¹ et R³ sont un alkyle en C₁-C₆ et R² est un hydrogène ou un alkyle en C₁-C₆,
dans un solvant organique, dans le même rapport des teneurs des métaux que dans l'oxyde métallique désiré ;
laisser le mélange réagir à la température de reflux ;
chasser le solvant ; et
irradier le résidu simultanément avec des rayons UV et des rayons IR.

2. Le procédé selon la revendication 1, dans lequel on utilise des alcoolates en C₁-C₄ de bismuth, de strontium et de calcium.

3. Le procédé selon la revendication 1 ou 2, dans lequel on utilise un solvant choisi parmi les alcools et les hydrocarbures aliphatiques et aromatiques.

4. Le procédé selon l'une quelconque des revendications 1 à 3, dans lequel on utilise un acétate, naphténate, 2-éthylhexanoate ou acétylacétonate de cuivre comme source de cuivre.

5. Le procédé selon l'une quelconque des revendications 1 à 4, dans lequel on utilise les rayons UV d'une lampe au mercure basse pression.

6. Le procédé selon l'une quelconque des revendications 1 à 5, dans lequel on effectue le reflux en présence d'eau.

7. Le procédé selon la revendication 6, dans lequel on effectue le reflux en présence d'eau et d'un catalyseur basique.

8. Le procédé selon l'une quelconque des revendications précédentes, dans lequel le produit de la réaction de reflux est appliqué à la surface d'un substrat et irradié après évaporation du solvant, pour former ainsi une pellicule mince dudit oxyde métallique.

9. Un procédé pour former une pellicule mince d'un oxyde métallique sur un substrat comprenant :
l'application à la surface du substrat du produit de la réaction à reflux d'une solution dans un solvant organique contenant
(1) un alcoolate en C₁-C₆ de bismuth,
(2) un alcoolate en C₁-C₆ de stontium,
(3) un alcoolate en C₁-C₆ de calcium et
(4) un formiate, propionate, acétate, citrate, gluconate, tartrate, oxalate, naphténate, 2-éthylhexanoate, complexe β-dicéto ou complexe β-cétoester de cuivre représentés par la formule
Cu(OR)ₗ(X)ₘ
dans laquelle R est un alkyle en C₁-C₆, l est 0 ou 1, m est 1 ou 2 et l + m = 2, et X est représenté par la formule 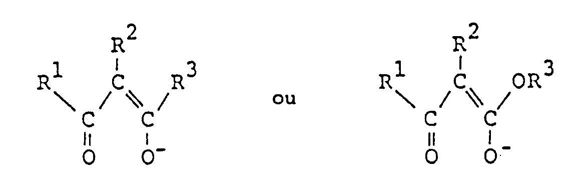 où R¹ et R³ sont un alkyle en C₁-C₆ et R² est un hydrogène ou un alkyle en C₁-C₆,
dans le même rapport des teneurs des métaux que dans l'oxyde métallique désiré ;
l'élimination du solvant ; et
l'irradiation du résidu simultanément avec des rayons UV et des rayons IR.
